# EUROPEAN PATENT SPECIFICATION

(11) **EP 1 521 514 B1**
(45) Date of publication and mention of the grant of the patent: **13.12.2017**
(21) Application number: 04021467.8
(22) Date of filing: 09.09.2004
(51) Int. Cl.: H05K 13/02

(54) **Parts feeder and component delivery apparatus**
Bauteilenzuführeinrichtung und Vorrichtung zum Abgeben von Komponenten.
Dispositif d'alimentation en pièces et dispositif de distribution de composants .

(30) Priority: 01.10.2003 JP 2003343701
(43) Date of publication of application: 06.04.2005
(73) Proprietor: YKK Corporation, Tokyo (JP)
(72) Inventor: Matsuda, Yasuhiko, Toyama-shi Toyama (JP); Daijogo, Shinichi, Kurobe-shi Toyama (JP)
(74) Representative: Leinweber & Zimmermann

(56) References cited:
- JP-A- 2000 136 019

## Description

### Background of the Invention

### Field of the Invention

The present invention relates to a parts feeder and a component delivery apparatus which arrange components having a heteromorphic section and a random directionality in one direction and sequentially deliver them to a next step, and more particularly to a parts feeder and a component delivery apparatus which can efficiently deliver components at a high speed.

### Description of the Related Art

Referring to an article constituted by a plurality of components, for example, a slide fastener, conventionally, assembly components are sequentially delivered to a component assembling device in the same posture in order of an assembly respectively and are assembled into predetermined portions. In a component delivery apparatus for supplying a component to the component assembling device, for example, components are arranged by using a bowl type vibrating parts feeder. Thus, the components arranged in the component assembling device are sequentially delivered. In the parts feeder of this type, there is provided a track for transferring a component which rises spirally along the internal surface of an external wall from the bottom portion of a bowl.

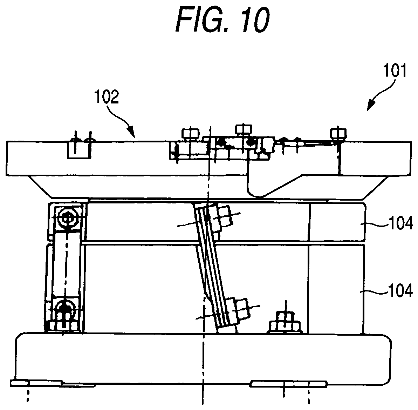

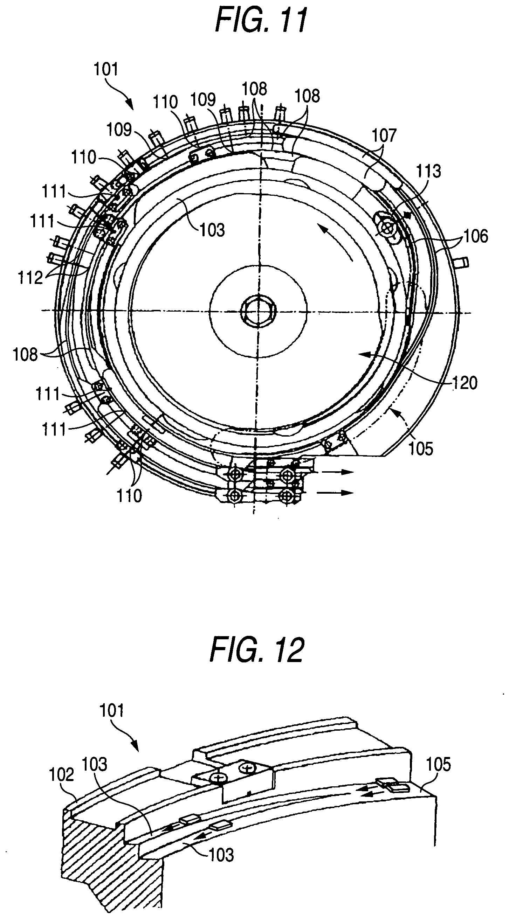

As an example of the parts feeder of this type, there has been a vibration type plural line component supply apparatus for arranging components in a plurality of lines and automatically supplying them (for example, see JP-A-2000-136019). In a vibration type plural line component supply apparatus 101 described in JP-A-2000-136019, a bottomed bowl 102 having a spiral track 103 along an internal wall surface is attached onto a vibrating member 104 as shown in Figs. 10 and 11.

As shown in Figs. 11 and 12, a dividing portion 105 for dividing and transferring components to be loaded in bulk on the bottom face of the bowl 102 into two lines in a component transfer direction is provided close to the bottom face side of the track 103 in the bowl 102. Furthermore, the track 103 is sequentially provided with an inducing and delivering portion 106, a direction arranging portion 107, a posture converting portion 108, a direction arranging portion 109, a double-side arranging portion 110, a component diverting portion 111, a double-side selecting portion 112, the posture converting portion 108, the component diverting portion 111 and the double-side arranging portion 110 from the dividing portion 105 in a lower part to an opening portion in the upper part of the bowl 102.

A component diverting portion 113 capable of discharging all components from the inside of the bowl 102 to the outside of the bowl 102 is provided along the track 103 on the upstream side of the dividing portion 105. The component diverting portion 113 is used when the type of the component is to be changed, and all of the components scattered over the bottom face of the bowl 102 are discharged to the outside of the bowl 102 through a component discharge hole formed on the wall portion of the bowl 102 by the vibration of the bowl 102 so that the inside of the bowl 102 can be empty.

In order to deliver the components by the conventional component supply apparatus 101, a vibration is applied to the bowl 102 by the vibration of the vibrating member 104. By the vibration of the bowl 102, the components scattered over the bottom face of the bowl 102 are collected onto the internal wall surface of the bowl 102 and are transferred and mounted on the spiral track 103. The components thus transferred and mounted are moved to the dividing portion 105.

The respective components divided into the two lines by the dividing portion 105 are sequentially fed to the inducing and delivering portion 106, the direction arranging portion 107, the posture converting portion 108, the direction arranging portion 109, the double-side arranging portion 110, the component diverting portion 111, the double-side selecting portion 112, the posture converting portion 108, the component diverting portion 111 and the double-side arranging portion 110. Thus, only the components having normal postures are successively transferred to an outlet formed on the opening portion in the upper part of the bowl 102 and are continuously supplied to the next steps.

At this time, the components delivered in abnormal postures other than a predetermined posture are diverted from the track 103 along the transfer of the components and are dropped into the bottom portion of the bowl 102.

JP-A-2000-136019 is referred to as a related art.

In the delivery of the component such as an element of a slide fastener, generally, there is provided a discharge chute for coupling the upper outlet of a bowl to a component assembling device. The discharge chute is supported by a vibrating device at the outside of the bowl. The component delivered over the track toward the upper outlet of the bowl and having a posture controlled is transferred to the component assembling device by the discharge chute to carry out a linear vibration.

The delivery of the component by the component delivery apparatus of this type is carried out by applying a vibration in a longitudinal direction in the discharge chute other than a vibration in a circumferential direction in the bowl. In the case in which the delivery speed of the component is to be increased, the number of the vibrations of the bowl is increased, thereby increasing the delivery speed of the component. When the number of the vibrations of the bowl is increased, the discharge chute receives a vibration generated from the bowl. Together with the vibration of the discharge chute carrying out the linear vibration, consequently, the vibration to be applied to the discharge chute is amplified, a swell is generated or a collision is generated between the discharge end of the bowl and the deliver-in end of the discharge chute.

Depending on the shape of the component, therefore, there is a problem in that the component is caught on the discharge chute on the way of the delivery, is not delivered into the discharge chute but is dropped, or falls from the discharge chute. In addition, in the case in which the component cannot be thus transferred reliably and smoothly, there is a problem in that the number of the components to be supplied to the component assembling device is decreased and an enhancement in a productivity cannot be expected.

In the track of the bowl which has a sharp up-gradient, particularly, a slip is apt to be generated between the component and the track of the bowl. In particular, the slip is apt to be generated for a component having a surface subjected to clear coating. When the slip is often generated, there is a problem in that the smooth transfer of the components is hindered so that a bad effect such as an arranging failure or a selecting failure is produced. By an increase in the number of the vibrations of the bowl, the slip generated between the component and the track of the bowl might be suppressed. Consequently, there is a new problem in that the components loaded in bulk over the bottom face of the bowl cannot be smoothly transferred upward and the components overlap with each other to cause clogging.

Moreover, it is hard to control the balance of a vibration between the bowl and the discharge chute. The component is often dropped on the way of the delivery into the discharge chute depending on a shape thereof. In addition, when the number of the vibrations of the bowl is increased, the delivery of the component is not carried out uniformly so that the component cannot be reliably transferred and mounted on the discharge chute. Consequently, there is a problem in that an enhancement in the supply efficiency of the component cannot be achieved.

In the vibration type plural line component supply apparatus 101 disclosed in JP-A-2000-136019, the delivery of the component depends on the vibration in the circumferential direction of the bowl 102. Therefore, it is not easy to smoothly advance the component upward from below the spiral track 103 and an increase in a component delivery speed is limited. In addition, it is not guaranteed that the component is reliably transferred and mounted from the track 103 onto the discharge chute, and a delivery interval between the components is increased or a time required for delivering the component is prolonged. Consequently, there is a drawback that a yield is reduced and a mass production is poor.

In recent years, the number of the types of the elements of a slide fastener is very large in the attachment of the same elements, for example. When zip teeth of the same type are to be assembled, a small lot production is often required.

In the conventional vibration type plural line component supply apparatus 101, however, the components scattered over the bottom face of the bowl 102 by the vibration of the bowl 102 are advanced upward from below along the track 103 inclined upward and are discharged from the component discharge hole formed on the wall portion of the bowl 102 to the outside of the bowl 102 along the track 103 as described above in order to discharge all of the components from the inside of the bowl 102 to the outside of the bowl 102 when the types of the components are to be changed. For this reason, there is a problem in that a planning property is considerably deteriorated when the type of the component is to be changed.

### Summary of the Invention

An object of the invention is to provide a parts feeder and a component delivery apparatus which can deliver a component in a predetermined posture reliably and smoothly, can implement a stable operation for a long period of time and a high-speed delivery, and furthermore, can be applied to a mass production and can sufficiently correspond to the assembly of several components.

The invention is directed to a parts feeder of vibration type for sequentially delivering a plurality of components, having: a guide surface on which the components put from an upper part of the parts feeder is transferred in a circumferential direction; and a component delivery path on which the components are arranged downward from above in a constant direction to be spirally delivered, wherein the component delivery path includes dividing paths in plural lines which serve to divide the components into a predetermined number of lines at an upstream side of the component delivery path, and components arranging and selecting means provided in each of the dividing paths, and the dividing paths are joined into one line at a downstream side of the component delivery path.

Furthermore, the guide surface is formed on an inclined surface gradually inclined downward toward the upstream side of the component delivery path.

Furthermore, an inside dividing path adjacent to an outside dividing path of the dividing paths is formed lower than the outside dividing path.

The invention is directed to a component delivery apparatus for sequentially delivering a plurality of components, having: a parts feeder of vibration type including a guide surface on which the components put from an upper part of the parts feeder is transferred in a circumferential direction, a component delivery path on which the components are arranged downward from above in a constant direction to be spirally delivered, components arranging and selecting means provided along the component delivery path, and a component discharge path from which the components diverted by the components arranging and selecting means are discharged to an outside; and transfer means for feeding back the components discharged from the component discharge path to the guide surface.

Furthermore, the transfer means is component transfer means for lifting and delivering the components discharged from the component discharge path upward from below the parts feeder.

Furthermore, the transfer means is component transfer means using air.

The invention is directed to a component delivery apparatus for sequentially delivering a plurality of components, having: a parts feeder of vibration type including a guide surface on which the components put from an upper part of the parts feeder is transferred in a circumferential direction, and a component delivery path on which the components are arranged downward from above in a constant direction to be spirally delivered, wherein the component delivery path includes dividing paths in plural lines which serve to divide the components into a predetermined number of lines at an upstream side of the component delivery path, and components arranging and selecting means provided in each of the dividing paths, in which the dividing paths are joined into one line at a downstream side of the component delivery path; and guide means for delivering the component fed from the component delivery path to a next step.

Furthermore, the guide means includes a component guide member connected to a downstream end of the component delivery path, wherein the component guide member has a component delivery space portion in which the components are sequentially arranged in one line to be delivered, and a fluid passage formed to partially communicate with both sides in a longitudinal direction of the component delivery space portion and in which a fluid passes in a delivery direction of the component.

The invention is directed to a component delivery apparatus for sequentially delivering a plurality of components, having: a parts feeder of vibration type including a guide surface on which the components put from an upper part of the parts feeder is transferred in a circumferential direction, a component delivery path on which the components are arranged downward from above in a constant direction to be spirally delivered, components arranging and selecting means provided along the component delivery path, and a component discharge path from which the components diverted by the components arranging and selecting means are discharged to an outside, wherein the component delivery path includes dividing paths in plural lines which serve to divide the components into a predetermined number of lines at an upstream side of the component delivery path, in which the dividing paths are joined into one line at a downstream side of the component delivery path; transfer means for feeding back the components discharged from the component discharge path to the guide surface; and guide means for delivering the component fed from the component delivery path to a next step.

Furthermore, each of the components is an element of a slide fastener, and an element attaching machine is provided on a downstream end of the guide means.

Furthermore, the element attaching machine includes a slide fastener tape supply device and an element crimping device.

The parts feeder of the invention can successively gather a plurality of components supplied and scattered toward the upper part of the guide surface by the vibration of the parts feeder so as to be collected toward the upstream side of the spiral component delivery path provided on the lower side of the guide surface. At the upstream side of the component delivery path, it is possible to arrange a large number of gathered components in the constant direction and to successively deliver them into the dividing paths in the plural lines of the component delivery path quickly and smoothly.

The components divided into the plural lines are sequentially fed to the downstream side of the dividing paths, respectively. At the downstream sides of the dividing paths, the dividing paths are joined into one line and the components joined into one line can be successively fed to the next steps. At this time, the components delivered in abnormal postures other than a normal posture can be diverted from the dividing path by the components arranging and selecting means provided along each of the dividing paths.

In the delivery of the components, the components divided into the plural lines above the parts feeder are joined into one line below the parts feeder. Consequently, a time required for delivering the components can be considerably shortened, and furthermore, the number of the components to be supplied can be increased. Thus, a production amount per unit time can be increased considerably and a manufacturing cost can be reduced greatly.

The guide surface is preferably formed on the inclined surface gradually inclined downward toward the upstream side of the component delivery path. A large number of components supplied and scattered over the upper guide surface can be successively gathered in a natural condition toward the spiral component delivery path provided in the lower part. Consequently, the components to be delivered can be gathered efficiently. Thus, the division of the components into each dividing path in the component delivery path can be carried out efficiently, smoothly and reliably. Furthermore, the components can be supplied stably to the next steps. In addition, the components can be delivered at a high speed.

The inside dividing path adjacent to an outside dividing path of the dividing paths is preferably formed lower than the outside dividing path. At the upstream side of the dividing path, therefore, it is possible to prevent the components from overlapping with each other on the inlet side of the dividing path, resulting in clogging at the inlet of the dividing path to impede the flow of the components when the components are to be delivered into the dividing path. Consequently, the components can be stably divided into a predetermined number of lines for a long period of time. It is possible to prevent a variation from being generated on the number of the components to be delivered into each of the dividing paths. Thus, a desirable number of components can be stably supplied to the next steps. The supply efficiency of the components can be enhanced, and furthermore, the delivery speed of the component can be increased.

In the component delivery apparatus of the invention, a plurality of components supplied and scattered over the upper part of the guide surface can be gathered toward the upstream side of the spiral component delivery path provided on the lower side of the guide surface by the vibration of the parts feeder, and the components thus gathered can be arranged in the constant direction and can be fed successively to the component delivery path. The components delivered over the component delivery path and arranged to control a posture in a normal condition can be fed to the next steps. At this time, the components fed over the component delivery path in different postures from the predetermined normal posture are dropped into the component discharge path and are diverted by the components arranging and selecting means provided along the component delivery path.

The components thus diverted can be discharged to the outside of the parts feeder through the component discharge path. The components discharged from the component discharge path can be reliably delivered from the lower portion of the parts feeder toward the upper portion through the transfer means, and can be directly fed back to the guide surface of the parts feeder quickly. The component returned to the guide surface can follow the component delivery path again together with the component supplied to the guide surface and can be fed to the next steps quickly and reliably. When the type of the component is to be changed, moreover, the component put on the guide surface can be diverted easily. Consequently, it is possible to enhance a planning property in the change.

As the transfer means, it is possible to use the component transfer means for lifting and delivering the components discharged through the component discharge path from the lower part of the parts feeder toward the upper part. As the typical configuration of the transfer means, a sucking delivery and a blow-up delivery are preferably carried out by using air.

In the component delivery apparatus of the invention, a plurality of components supplied and scattered above the upper guide surface can be gathered toward the upstream side of the spiral component delivery path provided under the guide surface by the vibration of the parts feeder. Moreover, the gathered components can be arranged in the constant direction and can be successively delivered into the dividing paths in the plural lines of the component delivery path.

The components divided into the plural lines are successively fed toward the downstream side of each of the dividing paths, and are joined into one line again at the downstream side, and are then fed to the next steps reliably and smoothly. At this time, the components transferred in the abnormal postures deviating from the predetermined normal posture are dropped from the dividing path into the component discharge path and are thus diverted by the components arranging and selecting means provided along each of the dividing paths.

The components delivered in the predetermined posture over the component delivery path are supplied to the guide means connected to the downstream end of the component delivery path. The components having postures controlled into the normal condition can be delivered quickly and smoothly to the next steps in the constant direction through the guide means.

The guide means is preferably connected to the component guide member at the downstream end of the component delivery path. The component guide member can sequentially arrange and deliver, in a line, the components delivered over the component delivery path into the component delivery space portion.

Furthermore, it is possible to form, on the component guide member, the fluid passage partially communicating with both sides in the longitudinal direction of the component delivery space portion without impeding the transfer of the components delivered in the component delivery space portion. It is possible to always introduce compressed air (air) injected from an air injection nozzle toward the fluid passage in the delivery direction of the component without causing the components to stay in the component delivery space portion, for example. Consequently, it is possible to more prevent the resonance of the vibration of the parts feeder and that of the component guide member as compared with a conventional method in which the component applies a vibration to the component guide member and is thus delivered.

The component to be delivered in the component delivery space portion can be accelerated to a predetermined speed by the injection of the compressed air and can be delivered at a high speed. By the injection of the compressed air and the natural slip of the component, the component can be fed in the component delivery space portion smoothly at a very high speed. It is possible to deliver the component fed from the component delivery portion to the component guide member at a high speed toward the next step while maintaining the directionality of the shape of the component by the compressed air injected toward the fluid passage through the air injection nozzle.

In the component delivery apparatus of the invention, a plurality of components supplied and scattered above the guide surface can be arranged in the constant direction and can be successively fed toward the upstream side of the spiral component delivery path provided under the guide surface by the vibration of the parts feeder. The component delivered over the component delivery path has a posture controlled into a normal condition through the guide means for a delivery to the next step, and can be sequentially delivered to the next step quickly and smoothly in the constant direction.

The component deviating from the normal posture on the way of the component delivery path is dropped into the component discharge path and is thus discharged by the components arranging and selecting means. Consequently, the component can be diverted to the outside of the parts feeder through the component discharge path. The component thus diverted can be delivered from the lower portion of the parts feeder toward the guide surface of the upper portion through the transfer means for feeding back the component to the guide surface, and can be fed back to the guide surface of the parts feeder quickly and directly. The component returned to the guide surface can be fed to the next step rapidly and stably following the component delivery path again together with the component supplied to the guide surface.

As described above, the component delivery apparatus of the invention can be used as a composite delivery structure collecting the vibration type parts feeder, the transfer means and the guide means. A delivery interval between the components can be maintained to be constant in the delivery, and furthermore, a time required for delivering the components can be considerably shortened. In addition, the delivery speed of the component can be increased and a productivity can be further enhanced.

In the component delivery apparatus of the invention, the component can be delivered quickly as described above. Therefore, the apparatus can also be applied to a mass production, and furthermore, can sufficiently correspond to the assembly of several components. The components can be effectively used for the delivery of the elements (zip teeth) of a slide fastener. In the delivery of the element, it is suitable that an element attaching machine should be provided on the downstream end of the guide means. The element attaching machine can be constituted by the slide fastener tape supply device and the element crimping device.

Also in the case in which a small number of zip teeth are to be arranged and delivered, the necessary number of zip teeth are put in and can be thus delivered quickly. Consequently, it is possible to reduce a manufacturing cost in addition to an enhancement in a productivity. In the attachment of the element of the slide fastener, moreover, the component is delivered in a predetermined posture reliably and smoothly. Consequently, it is possible to carry out a stable operation for a long period of time and a high-speed assembly.

Moreover, it is not necessary to provide a vibrating device for rectilinearly reciprocating the guide means, and the component can be smoothly transferred and mounted from the component delivery path onto the guide means.

### Brief Description of the Drawings

Fig. 1 is a general perspective view showing the schematic structure of a component delivery apparatus according to an embodiment of the invention;
Fig. 2 is a side view showing the component delivery apparatus;
Fig. 3 is a partially enlarged perspective view typically showing the parts feeder of the component delivery apparatus;
Fig. 4 is a partially enlarged perspective view showing the parts feeder in Fig. 3 as seen in another direction;
Fig. 5 is a partially enlarged view typically showing the circumference of an arrow V portion in Fig. 4;
Fig. 6 is a partially enlarged view typically showing the circumference of an arrow VI portion in Fig. 3;
Fig. 7 is an enlarged sectional view schematically showing the component guide member of the component delivery apparatus;
Fig. 8 is a sectional view seen in a VIII - VIII line in Fig. 7;
Fig. 9 is a partial perspective view schematically showing an example of the element crimping device of an element attaching machine to be applied to the component delivery apparatus;
Fig. 10 is a side view showing a conventional parts feeder;
Fig. 11 is a plan view showing the parts feeder; and
Fig. 12 is a partial perspective view showing the inner part of the parts feeder.

### Detailed Description of the Preferred Embodiments

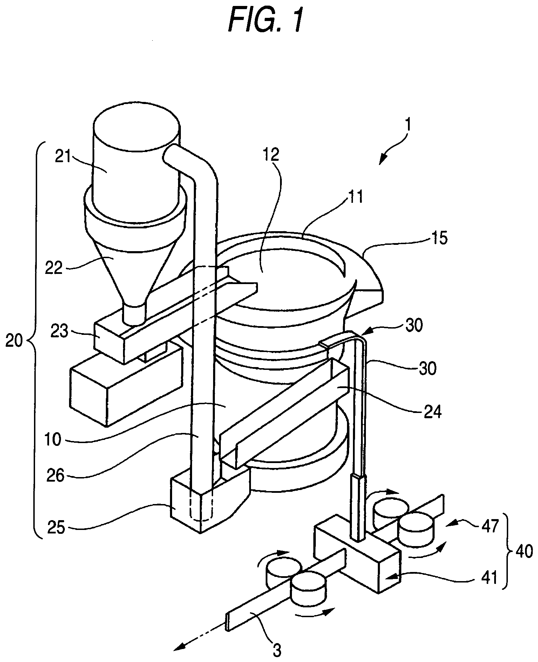

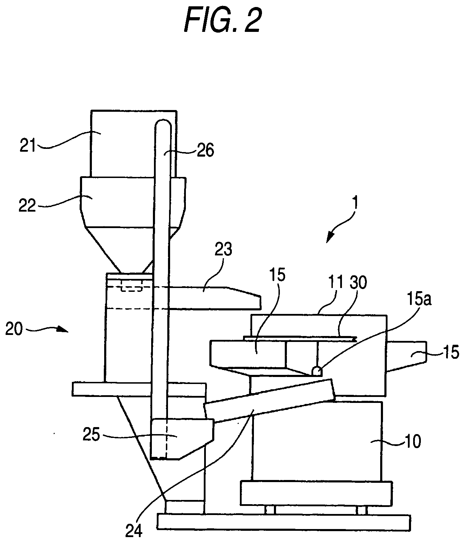

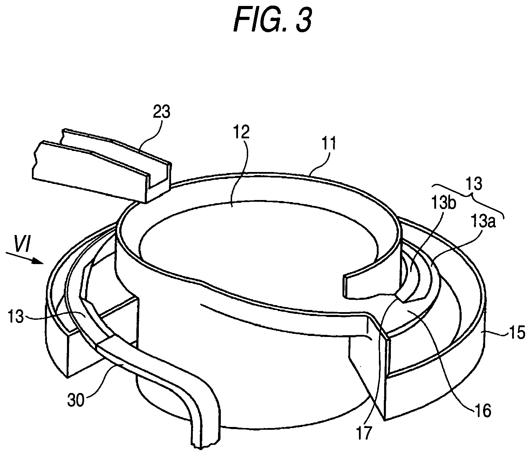

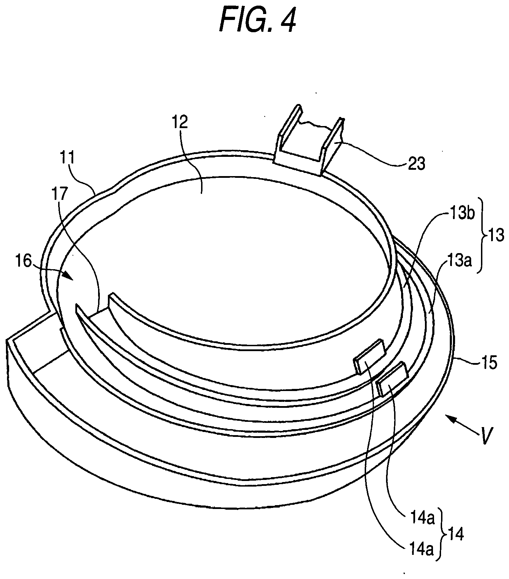

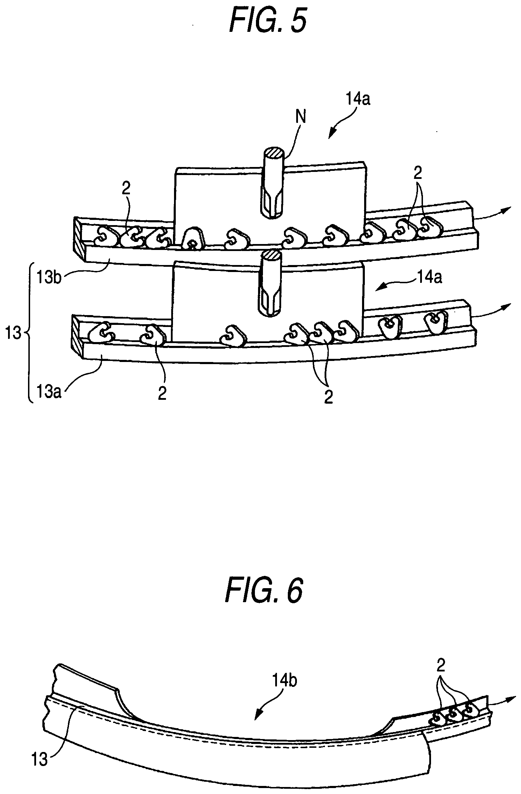

An embodiment of the invention will be specifically described below with reference to the accompanying drawings. Fig. 1 is a general perspective view showing the schematic structure of a component delivery apparatus according to an embodiment of the invention. Fig. 2 is a side view showing the component delivery apparatus. Fig. 3 is a partial enlarged perspective view typically showing the parts feeder of the component delivery apparatus. Fig. 4 is a partial enlarged perspective view showing the parts feeder of Fig. 3 as seen in another direction. In the embodiment, there is illustrated a continuous delivery apparatus for an element 2 of a slide fastener shown in Fig. 5.

As shown in Figs. 1 and 2, a component delivery apparatus 1 according to the embodiment has a base 10 supported on a floor face, and a circular vibration type parts feeder 11 attached onto the base 10 and vibrated by a vibration generator which is not shown.

As shown in Figs. 3 and 4, the parts feeder 11 has a guide surface 12 for diffusing a large number of components put into an upper part thereof in a circumferential direction, more specifically, the disc-shaped guide surface 12 inclined downward from a central part in the circumferential direction, and a component delivery path 13 for arranging and spirally delivering the components from an upper part of the parts feeder 11 toward a lower part in a constant direction. In Fig. 1, the component delivery path 13 is not shown. An external wall is formed in the outer peripheral portion of the guide surface 12 and a part of the external wall is taken away to form an inlet to the component delivery path 13.

While the guide surface 12 shown in the drawing takes the shape of a disc having the external wall formed in the outer peripheral portion in the drawings, moreover, the guide surface 12 is not restricted to the configuration described above but may take the shape of a semicircle, a fan, a square or a rectangular parallelepiped, for example, and preferably takes such a shape as to receive a large number of components to be put in and to smoothly transfer them to the component delivery path 13.

Furthermore, the parts feeder 11 has a components arranging and selecting means 14 (14a, 14b) shown in Figs. 5 and 6 which are provided along the component delivery path 13 along the component delivery path 13, and a component discharge path 15 shown in Figs. 3 and 4 which serves to discharge the component 2 diverted by the components arranging and selecting means 14 to an outside.

In addition, the component delivery apparatus 1 has a component transfer means 20 for returning, to the guide surface 12, the component discharged from the component discharge path 15 to the outside, and a component guide member 30 to be the component of guide means which is connected to the downstream side of the component delivery path 13 and serves to feed the component 2 to a next step as shown in Fig. 1. In the embodiment, the configuration of the parts feeder 11, the component transfer means 20 and the component guide member 30 are main feature portions.

As shown in Figs. 3 and 4, the guide surface 12 of the parts feeder 11 is formed to be an inclined surface which is inclined smoothly, gradually and downward toward the upstream side of the component delivery path 13 with a predetermined angle. The guide surface 12 has such a structure as to efficiently collect a large number of components supplied and scattered over the guide surface 12 to the upstream end of the spiral component delivery path 13 provided in a lower part by the vibration of the parts feeder 11, and furthermore, to successively deliver the components toward the component delivery path 13 in a natural condition.

As shown in Figs. 3 and 4, a dividing portion 16 for dividing the components into a predetermined number of lines, two lines in an example shown in the drawing and delivering them is formed between the lowest end of the guide surface 12 and the upstream end of the component delivery path 13. In the dividing portion 16, the component delivery path 13 is divided into an outside dividing path 13a and an inside dividing path 13b which serve to divide the components into the two lines and to transfer them as shown in Figs. 3 and 4. The inside dividing path 13b is formed like a groove having a lower step 17 than the outside dividing path 13a. Each of the dividing paths 13a and 13b gradually has such a component delivery path width as to deliver the components in one line in the component delivery direction and they are joined into one line again at the respective downstream sides of the dividing paths 13a and 13b.

In the case in which the components are to be arranged and delivered in at least three lines, the second dividing path 13b can be provided on the inside of the inside first dividing path 13a. Also in this case, it is suitable that the groove-shaped inlet of the second dividing path 13b should be formed with the lower step 17 than the groove-shaped inlet of the first dividing path 13a.

Thus, each of the dividing paths 13a and 13b branches through the step 17 in the dividing portion 16. With such a simple structure, consequently, it is possible to deliver a large number of components gathered to the dividing portion 16 into the respective dividing paths 13a and 13b without causing them to stay. Thus, it is possible to prevent the components from staying at the upstream side of each of the dividing paths 13a and 13b. Therefore, the components can be stably divided into a predetermined number of lines naturally for a long period of time.

Furthermore, the components can be continuously delivered into each of the dividing paths 13a and 13b. Consequently, it is possible to prevent a variation from being generated on the number of the components to be supplied which flow in each of the dividing paths 13a and 13b. Accordingly, a predetermined number of components can be supplied to a next step stably, quickly and smoothly and the supply efficiency of the component can be enhanced, and furthermore, the delivery speed of the component can be increased.

When a vibration is applied to the parts feeder 11 by the operation of a vibration generator which is not shown, a large number of components put in the guide surface 12 of the parts feeder 11 are successively gathered toward the dividing portion 16. In the dividing portion 16, a large number of components thus gathered can be arranged in a constant direction and can be successively delivered into each of the dividing paths 13a and 13b quickly and smoothly.

The respective components delivered over each of the dividing paths 13a and 13b can be sequentially transferred to the downstream side of each of the dividing paths 13a and 13b vibrated in a longitudinal direction by the vibration generator which is not shown, and can be joined into one line at the downstream side and can be then fed to the next step successively. By the vibration and the downward inclination of each of the dividing paths 13a and 13b, the large number of components can be advanced smoothly at a very high speed over each of the dividing paths 13a and 13b. The guide surface 12 and each of the dividing paths 13a and 13b can be excited by one vibration generator or separate vibration generators.

In the delivery of the components, thus, the components divided into the plural lines in the upper portion of the parts feeder 11 are joined into one line again in the lower portion of the parts feeder 11. Consequently, the time required for delivering the components can be shortened considerably, and furthermore, the number of the components to be supplied can be increased. Thus, a production per unit time can be considerably increased and a manufacturing cost can be greatly reduced.

Thus, the component delivery path 13 can be divided into the dividing paths 13a and 13b and can be joined into one line again. Consequently, the arrangement and selection can be efficiently carried out by the components arranging and selecting means 14 (14a, 14b) provided in the dividing paths 13a and 13b. Even if the number of the components 2 to be supplied through the components arranging and selecting means 14 (14a, 14b) is decreased, furthermore, they are joined into one line again and can be thus supplied without a decrease in the amount of supply to the component guide member 30 for final supply.

When the components are moved forward over each of the dividing paths 13a and 13b, the components delivered in abnormal postures other than a normal posture can be dropped into the component discharge path 15 by the components arranging and selecting means 14 shown in Figs. 5 and 6 which is provided along each of the dividing paths 13a and 13b and can be thus diverted. The component 2 thus diverted can be discharged to the outside of the parts feeder 11 through the component discharge path 15. While some selecting methods are described as the components arranging and selecting means 14, the components arranging and selecting means 14 in the embodiment includes direction arranging means, posture converting means and double-side selecting means for the component and can also be provided in each of the dividing paths 13a and 13b.

The component discharge path 15 is provided under the component delivery path 13 and is extended with a gradual downward inclination at least from the upstream side of the dividing portion 16 to the lowest end of the component delivery path 13 over the external wall surface of the parts feeder 11 as shown in Figs. 3 and 4. A discharge port 15a is formed on the lowermost end of the component discharge path 15 as shown in Figs. 2 and 3.

Fig. 5 is a partial enlarged view typically showing the circumference of an arrow V portion in Fig. 4, and Fig. 6 is a partial enlarged view typically showing the circumference of an arrow VI portion in Fig. 3. The invention is not restricted to the example shown in the drawing.

The components arranging and selecting means 14 including the first components arranging and selecting means 14a for selecting the surface and back of a component as shown in Fig. 5 and the second components arranging and selecting means 14b for selecting the (longitudinal) directionality of the component as shown in Fig. 6 are provided along the component delivery path 13. The components arranging and selecting means 14 has such a structure as to divert the component 2 fed over the component delivery path 13 in a different abnormal posture from a predetermined posture and to discharge The component 2 to the component discharge path 15.

The first components arranging and selecting means 14a can select and arrange the surface and back of the component 2 divided into the two lines by means of the dividing portion 16 as shown in Fig. 5. The first components arranging and selecting means 14a discharges the component 2 having a back face exposed to the component discharge path 15 through an air nozzle N provided on each of the dividing paths 13a and 13b, and only the component 2 having a surface exposed is transferred to the downstream side over each of the dividing paths 13a and 13b rapidly and smoothly. The operation of the air nozzle N can be carried out by detecting the surface and back of the component 2 by means of a general surface and back discriminating sensor and operating the air nozzle N based on the result of the detection. While the description has been given to the example in which the component having the back face exposed is discharged to the component discharge path 15, the component having the back face exposed is not limitedly selected by means of the air nozzle N but the component having the surface exposed can also be discharged to the component discharge path 15.

More specifically, the surface and the back of the component 2 are not shown in the drawing but have different shapes from each other. In the case in which the surface is exposed, for example, the delivery is carried out without a clearance between the dividing paths 13a and 13b and the component 2. On the other hand, in the case in which the back face is exposed, the clearance is formed between the dividing paths 13a and 13b and the component 2 to carry out the delivery. In case of the component 2 having the back face exposed, for example, the component 2 is dropped from the dividing paths 13a and 13b into the component discharge path 15 by an air pressure applied from the air nozzle N provided in the middle and is discharged to the outside through the component discharge path 15. In case of the component 2 of which surface and back do not need to be selected (the surface and the back have identical shapes), particularly, it is not necessary to provide the first arranging and selecting member 14a.

As shown in Fig. 6, the second components arranging and selecting means 14b is provided in the component delivery path 13 joined into one line at the downstream sides of the dividing paths 13a and 13b. The second components arranging and selecting means 14b can select and arrange the (longitudinal) direction of the component 2 having the surface and back selected in the first components arranging and selecting means 14a. More specifically, the forward component 2 turned toward one side with respect to a transfer direction is delivered to the downstream side over the component delivery path 13, for example. On the other hand, the rearward component 2 turned toward the other side with respect to the transfer direction is dropped from the component delivery path 13 into the component discharge path 15 and is thus discharged, for example. Only the forward component 2 turned toward one side is transferred to the downstream side over the component delivery path 13 rapidly and smoothly, for example.

More specifically, for example, the (forward) component 2 turned toward one side with respect to the transfer direction is delivered through a support on front and rear walls formed with the component delivery path 13 interposed therebetween, and the component delivery path 13 is formed to take such a shape as not to support, with the front and rear walls of the component delivery path 13, the (rearward) component 2 turned toward the other side with respect to the transfer direction. Consequently, the (rearward) component 2 turned toward the other side is dropped by the deadweight of the component 2 through a circular-arc shaped notch formed on the rear wall, for example.

The component 2 discharged from the discharge port 15a of the component discharge path 15 can be reliably delivered upward from below the parts feeder 11 through the component transfer means 20 shown in Fig. 1, and can be directly fed back to the guide surface 12 of the parts feeder 11 quickly. The component 2 returned to the guide surface 12 can be fed out to the next step quickly and reliably following the component delivery path 13 again.

For the component transfer means 20, it is possible to use component transfer means for lifting and delivering the component 2 discharged from the component discharge path 15 upward from below the parts feeder 11.

In the embodiment, as shown in Fig. 1, the component transfer means 20 includes a cyclone 21 and a hopper 22, a rectilinear type parts feeder 23 for introducing the component 2 put in through the hopper 22 into the guide surface 12 of the parts feeder 11, a discharge chute 24 linked in contact with the downstream side of the component discharge path 15, a storing portion 25 for temporarily storing the component 2 fed from the component discharge path 15 through the discharge chute 24, and sucking means 26 for transferring the component 2 stored in the storing portion 25 into the cyclone 21.

The component 2 dropped into the component discharge path 15 is temporarily stored in the storing portion 25 from the discharge port 15a of the component discharge path 15 through the discharge chute 24 as shown in Fig. 1. The stored component 2 is automatically fed back to the cyclone 21 by compressed air through the operation of the sucking means 26. Moreover, the discharge chute 24 can be used for discharging the component 2 in the guide surface 12 of the parts feeder 11, the component delivery path 13 and the component discharge path 15 when the type of the component 2 is to be changed. The component 2 put on the guide surface 12 can be rapidly transferred to the discharge chute 24 and can be removed together with the components 2 in the component delivery path 13 and the component discharge path 15. At this time, it is preferable that a container should be provided on the downstream of the discharge chute 24 so as not to be connected with the sucking means 26 differently from the storing portion 25, which is not shown. Consequently, the component 2 can be transferred to flow from an upper part toward a lower part and the component 2 can be discharged in a short time when the type of the component 2 is to be changed.

In place of the sucking means 26, it is also possible to lift and deliver the component 2 by compressed air injected from an injection nozzle. Moreover, proper delivery means can be used, for example, a non-end delivery belt inclined upward from the storing portion 25 toward the cyclone 21 or the hopper 22 is used in place of the sucking means 26. The non-end delivery belt which is not shown can be provided to be driven and rotated in one direction by means of a driving motor in such a manner that a driving speed thereof can be varied.

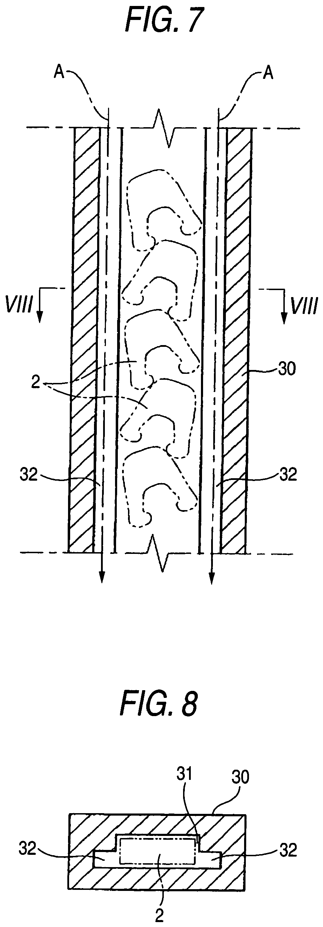

The component 2 delivered over the component delivery path 13 in a predetermined posture is transferred to component guide means connected to the downstream end of the component delivery path 13 as shown in Fig. 1. The component guide means has the tubular component guide member 30 having a rectangular component delivery space portion 31 as shown in Figs. 7 and 8. The component guide member 30 has an upstream side thereof coupled rectilinearly to the downstream end of the component delivery path 13 and is bent and extended downward toward the next step in the middle thereof.

Fig. 7 is an enlarged sectional view schematically showing the component guide member 30 of the component delivery apparatus 1, and Fig. 8 is a sectional view seen in an arrow of a VIII - VIII line in Fig. 7.

In these drawings, the component guide member 30 can sequentially arrange and deliver the components 2 delivered along the component delivery path 13 in a line into the component delivery space portion 31.

The component guide member 30 is coincident with a partial peripheral surface on both sides in a longitudinal direction over the whole length of the component delivery space portion 31, and has two fluid passages 32 and 32 penetrating in the longitudinal direction. The inner part of the component guide member 30 can be constituted by a tubular member having a convex-shaped through space penetrating in the longitudinal direction. The fluid passage 32 can always introduce compressed air A injected from an air injection nozzle (not shown) in the transfer direction of the component 2 without impeding the transfer of the component 2 passing through the inside of the component delivery space portion 31, for example.

By the compressed air A injected toward the fluid passage 32 through the air injection nozzle, it is possible to maintain the directionality of the shape of the component 2. Since the component 2 fed in the component guide member 30 is naturally dropped together with the injection of the compressed air A, an acceleration to a predetermined speed is carried out so that a high-speed delivery can be performed.

The component delivery apparatus 1 can be constituted by a composite delivery structure having the parts feeder 11, the component transfer means 20 and the component guide member 30 provided together. A delivery interval between the components 2 in the delivery can be maintained to be constant, and furthermore, a time required for delivering the component 2 can be shortened considerably. In addition, the delivery speed of the component 2 can be increased so that a productivity can be enhanced.

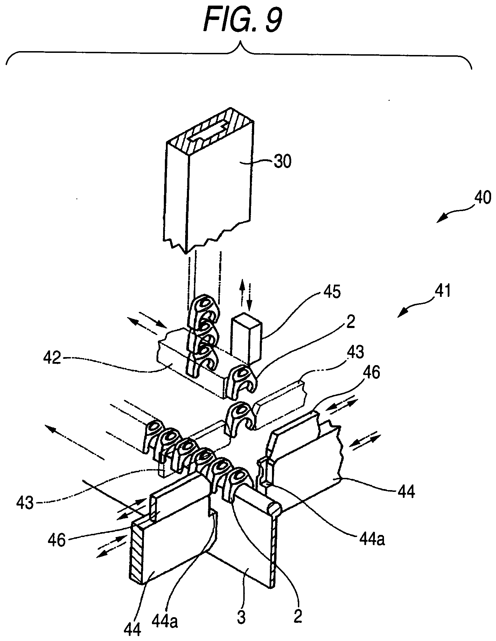

Since the component delivery apparatus 1 can deliver the component 2 quickly, it can also be applied to a mass production, and furthermore, can be caused to sufficiently correspond to the assembly of several components 2. The component 2 fed into the component guide member 30 can be transferred smoothly and quickly toward an element attaching machine 40 shown in Fig. 9.

Fig. 9 is a partial perspective view schematically showing an example of an element crimping device 41 of the element attaching machine 40 to be applied to the component delivery apparatus 1. In Fig. 9, the element attaching machine 40 is constituted by the element crimping device 41 and a slide fastener tape supply device 47 shown in Fig. 1. The element crimping device 41 is provided on the downstream end of the component guide member 30.

In the element crimping device 41, a plurality of components (elements) 2, ..., 2 is sequentially arranged and fed in a line in the component guide member 30, and the elements 2 are caused to intermittently abut, one by one, on a supply rod 42 reciprocated in a transverse direction with respect to the element 2 in a lowermost position and are transferred to the predetermined attachment position of a fastener tape 3. At this time, the element 2 is supplied in such a posture that a mating head portion is turned upward and two leg portions are turned downward. The element 2 transferred by the supply rod 42 is dropped by a deadweight, and is supported between a pair of stoppers 43 and 43 and is temporarily stopped as shown in a two-dotted chain line of Fig. 9.

A pair of attaching punches 44 and 44 standing by in a retreated position are advanced toward the fastener tape 3 with the fastener tape 3 interposed therebetween, and are once stopped at a predetermined interval. The element 2 supported by the pair of stoppers 43 and 43 pushes the mating head portion of the element 2 from above through a press rod 45 reciprocated in a vertical direction. Consequently, an interval between the stoppers 43 and 43 is enlarged to drop the supported element 2 downward by a deadweight. The element 2 thus dropped is provided across a tape edge portion protruded to take almost the circular sectional shape of the fastener tape 3 positioned thereunder.

The press rod 45 is moved downward further continuously and abuts on the upper part of the mating head portion of the element 2, thereby holding the element 2 so as not to get out upward in the attachment of the element 2. At this time, the lower end of the leg portion of the element 2 is supported on a step portion 44a of the attaching punch 44 so that the attachment position of the element 2 is determined. In the case in which the posture of the element 2 is inclined, a pair of posture control rods 46 and 46 are advanced to abut on the side part of the mating head portion of the element 2, thereby carrying out a correction to a normal posture to be maintained.

Each of the attaching punches 44 is advanced again to press the leg portion of the element 2 from a side and to interpose the fastener tape 3, thereby attaching the element 2. When the attachment of the element 2 is completed, the posture control rod 46 and the attaching punch 44 are moved backward and the press rod 45 is lifted upward. Subsequently, the fastener tape 3 is moved by an interval from such a position as to attach the next element 2.

Thus, the element 2 can be always attached accurately in a correct condition in parallel with the surface of the fastener tape 3, and furthermore, a work for attaching the element 2 can be carried out at a high speed. Even if a small number of elements to be required are put in, they can be delivered quickly. Consequently, a productivity can be enhanced, and furthermore, an inexpensive slide fastener can be obtained. In the attachment of the element 2 of the slide fastener, moreover, the element 2 can be delivered reliably and smoothly in a predetermined posture. Consequently, it is possible to implement a stable operation for a long period of time and a high-speed assembly. The type and configuration of the component and the manner of the supply are illustrative and the invention is not restricted thereto.

The parts feeder and the component delivery apparatus of the invention are not restricted to an apparatus for delivering the element of the slide fastener but can be applied to a small article such as a button, or an electronic component such as a capacitor unit, an RC composite unit or a chip resistor.

## Claims

1. A parts feeder (11) of vibration type for sequentially delivering a plurality of components (2), comprising:
a guide surface (12) on which the components (2) put from an upper part of the parts feeder (11) is transferred in a circumferential direction; and
a component delivery path (13) on which the components (2) are arranged downward from above in a constant direction to be spirally delivered,
wherein the component delivery path (13) includes dividing paths (13a, 13b) in plural lines which serve to divide the components (2) into a predetermined number of lines at an upstream side of the component delivery path (13), and components arranging and selecting means (14) provided in each of the dividing paths (13a, 13b),
**characterized in that** the dividing paths (13a, 13b) are joined into one line at a downstream side of the component delivery path (13).

2. The parts feeder according to claim 1,
wherein the guide surface (12) is formed on an inclined surface gradually inclined downward toward an upstream side of the component delivery path (13).

3. The parts feeder according to claim 1 or 2,
wherein an inside dividing path (13b) adjacent to an outside dividing path (13a) of the dividing paths (13a, 13b) is formed lower than the outside dividing path (13a).

4. A component delivery apparatus (1) for sequentially delivering a plurality of components (2), comprising:
a parts feeder (11) of vibration type including a guide surface (12) on which the components (2) put from an upper part of the parts feeder (11) is transferred in a circumferential direction, and a component delivery path (13) on which the components (2) are arranged downward from above in a constant direction to be spirally delivered, wherein the component delivery path (13) includes dividing paths (13a, 13b) in plural lines which serve to divide the components (2) into a predetermined number of lines at an upstream side of the component delivery path (13), and components arranging and selecting means (14) provided in each of the dividing paths (13a, 13b); and
guide means for delivering the component (2) fed from the component delivery path (13) to a next step,
**characterized in that**
the dividing paths (13a, 13b) are joined into one line at a downstream side of the component delivery path (13).

5. The component delivery apparatus according to claim 4,
wherein the guide means includes a component guide member (30) connected to a downstream end of the component delivery path (13), wherein the component guide member (30) has a component delivery space portion (31) in which the components (2) are sequentially arranged in one line to be delivered, and a fluid passage (32) formed to partially communicate with both sides in a longitudinal direction of the component delivery space portion (31) and in which a fluid passes in a delivery direction of the component (2).

6. A component delivery apparatus (1) for sequentially delivering a plurality of components (2), according to claim 4, comprising:
a parts feeder (11) of vibration type including a guide surface (12) on which the components (2) put from an upper part of the parts feeder (11) is transferred in a circumferential direction, a component delivery path (13) on which the components (2) are arranged downward from above in a constant direction to be spirally delivered, components arranging and selecting means (14) provided along the component delivery path (13), and a component discharge path (15) from which the components (2) diverted by the components arranging and selecting means (14) are discharged to an outside, wherein the component delivery path (13) includes dividing paths (13a, 13b) in plural lines which serve to divide the components (2) into a predetermined number of lines at an upstream side of the component delivery path (13);
transfer means for feeding back the components (2) discharged from the component discharge path (15) to the guide surface (12); and
guide means for delivering the component (2) fed from the component delivery path (13) to a next step,
**characterized in that**
the dividing paths (13a, 13b) are joined into one line at a downstream side of the component delivery path (13).

7. The component delivery apparatus according to claim 6,
wherein each of the components (2) is an element of a slide fastener, and an element attaching machine (40) is provided on a downstream end of the guide means.

8. The component delivery apparatus according to claim 7,
wherein the element attaching machine (40) includes a slide fastener tape supply device (47) and an element crimping device (41).

## Patentansprüche

1. Bauteilzuführeinrichtung (11) vom Vibrationstyp für aufeinander folgendes Zuführen einer Mehrzahl von Bestandteilen (2), wobei die Einrichtung umfasst:
eine Führungsfläche (12), auf der die von einem oberen Teil der Bauteilzuführeinrichtung (11) angeordneten Bestandteile (2) in einer Umfangsrichtung übertragen werden; und
einen Bestandteilzufuhrweg (13), auf dem die Bestandteile (2) von oben nach unten in einer konstanten Richtung ausgerichtet werden, um spiralartig zugeführt zu werden,
wobei der Bestandteilzufuhrweg (13) umfasst: Unterteilungswege (13a, 13b) in einer Mehrzahl von Linien, die dazu dienen, die Bestandteile (2) in eine vorbestimmte Anzahl von Linien an einer stromaufwärts gelegenen Seite des Bestandteilzufuhrwegs (13) zu unterteilen, und ein Mittel (14) zum Ausrichten und Auswählen von Bestandteilen, das in jedem der Unterteilungswege (13a, 13b) zur Verfügung gestellt ist,
**dadurch gekennzeichnet, dass** die Unterteilungswege (13a, 13b) an einer stromabwärts gelegenen Seite des Bestandteilzufuhrwegs (13) in eine einzige Linie zusammengefasst werden.

2. Bauteilzuführeinrichtung gemäß Anspruch 1,
wobei die Führungsfläche (12) auf einer geneigten Oberfläche ausgeformt ist, die sich nach und nach in Richtung einer stromaufwärts gelegenen Seite des Bestandteilzufuhrwegs (13) nach unten neigt.

3. Bauteilzuführeinrichtung gemäß Anspruch 1 oder 2,
wobei ein innerer Unterteilungsweg (13b) angrenzend an einen äußeren Unterteilungsweg (13a) aus den Unterteilungswegen (13a, 13b) weiter unten als der äußere Unterteilungsweg (13a) ausgeformt ist.

4. Bestandteilzufuhrvorrichtung (1) zum aufeinander folgenden Zuführen einer Mehrzahl von Bestandteilen (2), wobei die Vorrichtung umfasst:
eine Bauteilzuführeinrichtung (11) vom Vibrationstyp, die umfasst: eine Führungsfläche (12), auf der die von einem oberen Teil der Bauteilzuführeinrichtung (11) angeordneten Bestandteile (2) in einer Umfangsrichtung übertragen werden; und einen Bestandteilzufuhrweg (13), auf dem die Bestandteile (2) von oben nach unten in einer konstanten Richtung ausgerichtet werden, um spiralartig zugeführt zu werden, wobei der Bestandteilzufuhrweg (13) umfasst: Unterteilungswege (13a, 13b) in einer Mehrzahl von Linien, die dazu dienen, die Bestandteile (2) in eine vorbestimmte Anzahl von Linien an einer stromaufwärts gelegenen Seite des Bestandteilzufuhrwegs (13) zu unterteilen, und ein Mittel (14) zum Ausrichten und Auswählen von Bestandteilen, die in jedem der Unterteilungswege (13a, 13b) zur Verfügung gestellt ist, und
ein Führungsmittel zum Zuführen des von dem Bestandteilzufuhrweg (13) zugeführten Bestandteils (2) an einen nächsten Schritt,
**dadurch gekennzeichnet, dass**
die Unterteilungswege (13a, 13b) an einer stromabwärts gelegenen Seite des Bestandteilzufuhrwegs (13) in eine einzige Linie zusammengefasst werden.

5. Bestandteilzufuhrvorrichtung gemäß Anspruch 4,
wobei das Führungsmittel umfasst: ein Bestandteilführungselement (30), das mit einem stromabwärts gelegenen Ende des Bestandteilzufuhrwegs (13) verbunden ist, wobei das Bestandteilführungselement (30) aufweist: einen Bestandteilzufuhrraumabschnitt (31), in dem die Bestandteile (2) aufeinander folgend in einer Linie ausgerichtet werden, um zugeführt zu werden, und einen Flüssigkeitsdurchgang (32), der dazu ausgeformt ist, zum Teil mit beiden Seiten in einer Längsrichtung des Bestandteilzufuhrraumabschnitts (31) zu kommunizieren, und in dem eine Flüssigkeit in einer Zufuhrrichtung der Bestandteile (2) strömt.

6. Bestandteilzufuhrvorrichtung (1) zum aufeinander folgenden Zuführen einer Mehrzahl von Bestandteilen (2) gemäß Anspruch 4, wobei die Vorrichtung umfasst:
eine Bauteilzuführeinrichtung (11) vom Vibrationstyp, die umfasst: eine Führungsfläche (12), auf der die von einem oberen Teil der Bauteilzuführeinrichtung (11) angeordneten Bestandteile (2) in einer Umfangsrichtung übertragen werden, einen Bestandteilzufuhrweg (13), auf dem die Bestandteile (2) von oben nach unten in einer konstanten Richtung ausgerichtet werden, um spiralartig zugeführt zu werden, ein Mittel (14) zum Ausrichten und Auswählen von Bestandteilen, welches Mittel an dem Bestandteilzufuhrweg (13) entlang zur Verfügung gestellt ist, und einen Bestandteilentladungsweg (15), von dem die von dem Mittel (14) zum Ausrichten und Auswählen von Bestandteilen umgeleiteten Bestandteile (2) nach außen entladen werden; wobei der Bestandteilzufuhrweg (13) umfasst: Unterteilungswege (13a, 13b) in einer Mehrzahl von Linien, die dazu dienen, die Bestandteile (2) in eine vorbestimmte Anzahl von Linien an einer stromaufwärts gelegenen Seite des Bestandteilzufuhrwegs (13) zu unterteilen;
ein Übertragungsmittel zum Zurückführen der von dem Bestandteilentladungsweg (15) an die Führungsfläche (12) entladenen Bestandteile (2); und
ein Führungsmittel zum Zuführen des von dem Bestandteilzufuhrweg (13) zugeführten Bestandteils (2) an einen nächsten Schritt,
**dadurch gekennzeichnet, dass**
die Unterteilungswege (13a, 13b) an einer stromabwärts gelegenen Seite des Bestandteilzufuhrwegs (13) in eine einzige Linie zusammengefasst werden.

7. Bestandteilzufuhrvorrichtung gemäß Anspruch 6,
wobei es sich bei jedem der Bestandteile (2) um ein Kuppelglied eines Reißverschlusses handelt, und eine Kuppelgliedbefestigungsvorrichtung (40) an einem stromabwärts gelegenen Ende des Führungsmittels zur Verfügung gestellt ist.

8. Bestandteilzufuhrvorrichtung gemäß Anspruch 7,
wobei die Kuppelgliedbefestigungsvorrichtung (40) eine Einrichtung (47) zum Zuführen eines Reißverschlusstragbands und eine Einrichtung (41) zum Crimpen der Kuppelglieder umfasst.

## Revendications

1. Dispositif d'alimentation en pièces (11) de type vibratoire permettant l'apport consécutif d'une pluralité de composants (2), comprenant :
une surface de guidage (12) sur laquelle les composants (2) introduits depuis une partie supérieure du dispositif d'alimentation en pièces (11) sont transférés dans un sens circonférentiel, et
une voie d'apport de composants (13) sur laquelle les composants (2) sont agencés descendants dans un sens constant en spirale en vue de leur distribution ;
ladite voie d'apport de composants (13) comprenant des voies de séparation (13a, 13b) en lignes multiples qui servent à séparer les composants (2) selon un nombre prédéterminé de lignes sur un côté amont de la voie d'apport de composants (13), et un moyen de disposition et de sélection de composants (14) prévu sur chacune des voies de séparation (13a, 13b) ;
**caractérisé en ce que** les voies de séparation (13a, 13b) se rejoignent pour former une ligne unique sur un côté aval de la voie d'apport de composants (13).

2. Dispositif d'alimentation en pièces selon la revendication 1,
dans lequel la surface de guidage (12) est constituée sur une surface inclinée, descendant graduellement vers un côté amont de la voie d'apport de composants (13).

3. Dispositif d'alimentation en pièces selon la revendication 1 ou 2,
dans lequel une voie de séparation intérieure (13b) contiguë à une voie de séparation extérieure (13a) des voies de séparation (13a, 13b) est constituée plus bas que la voie de séparation extérieure (13a).

4. Dispositif d'apport de composants (1) permettant l'apport consécutif d'une pluralité de composants (2), comprenant :
un dispositif d'alimentation en pièces (11) de type vibratoire comprenant une surface de guidage (12) sur laquelle les composants (2) introduits depuis une partie supérieure du dispositif d'alimentation en pièces (11) sont transférés dans un sens circonférentiel, et une voie d'apport de composants (13) sur laquelle les composants (2) sont agencés descendants dans un sens constant en spirale en vue de leur distribution, ladite voie d'apport de composants (13) comprenant des voies de séparation (13a, 13b) en lignes multiples qui servent à séparer les composants (2) selon un nombre prédéterminé de lignes sur un côté amont de la voie d'apport de composants (13), et un moyen de disposition et de sélection de composants (14) prévu sur chacune des voies de séparation (13a, 13b), et
un moyen de guidage permettant d'apporter le composant (2) issu de la voie d'apport de composants (13) vers l'étape suivante ;
**caractérisé en ce que**
les voies de séparation (13a, 13b) se rejoignent pour former une ligne unique sur un côté aval de la voie d'apport de composants (13).

5. Dispositif d'apport de composants selon la revendication 4,
dans lequel le moyen de guidage comprend un élément de guidage de composants (30) relié à une extrémité aval de la voie d'apport de composants (13), ledit élément de guidage de composants (30) présentant une partie d'espace d'apport de composants (31) dans laquelle les composants (2) sont disposés les uns à la suite des autres selon une ligne en vue de leur apport, et un passage de fluide (32) constitué pour communiquer partiellement avec les deux côtés dans le sens longitudinal de la partie d'espace d'apport de composants (31) et dans lequel passe un fluide dans un sens d'apport du composant (2).

6. Dispositif d'apport de composants (1) permettant l'apport consécutif d'une pluralité de composants (2), selon la revendication 4, comprenant :
un dispositif d'alimentation en pièces (11) de type vibratoire comprenant une surface de guidage (12) sur laquelle les composants (2) introduits depuis une partie supérieure du dispositif d'alimentation en pièces (11) sont transférés dans un sens circonférentiel, une voie d'apport de composants (13) sur laquelle les composants (2) sont agencés descendants dans un sens constant en spirale en vue de leur distribution, un moyen de disposition et de sélection de composants (14) prévu le long de la voie d'apport de composants (13), et une voie d'évacuation de composants (15) permettant d'évacuer vers l'extérieur les composants (2) déviés par le moyen de disposition et de sélection de composants (14) ; ladite voie d'apport de composants (13) comprend des voies de séparation (13a, 13b) en lignes multiples qui servent à séparer les composants (2) selon un nombre prédéterminé de lignes sur un côté amont de la voie d'apport de composants (13),
un moyen de transfert permettant de renvoyer les composants (2) évacués de la voie d'évacuation de composants (15) vers la surface de guidage (12), et
un moyen de guidage permettant d'apporter le composant (2) issu de la voie d'apport de composants (13) vers l'étape suivante,
**caractérisé en ce que**
les voies de séparation (13a, 13b) se rejoignent pour former une ligne unique sur un côté aval de la voie d'apport de composants (13).

7. Dispositif d'apport de composants selon la revendication 6,
dans lequel chacun des composants (2) est un élément d'une fermeture à glissière, et une machine de fixation d'éléments (40) est prévue sur une extrémité aval du moyen de guidage.

8. Dispositif d'apport de composants selon la revendication 7,
dans lequel la machine de fixation d'éléments (40) comprend un dispositif d'amenée de ruban de fermeture à glissière (47) et un dispositif de sertissage d'élément (41).
